# FASCICULE DE BREVET EUROPEEN

(11) **EP 4 449 477 B1**
(45) Date de publication et mention de la délivrance du brevet: **31.12.2025**
(21) Numéro de dépôt: 22840798.7
(22) Date de dépôt: 13.12.2022
(51) Int. Cl.: H01L 21/02, H01L 21/18

(54) **PROCEDE DE FABRICATION D'UNE STRUCTURE SEMI-CONDUCTRICE COMPRENANT UN SUBSTRAT DE CARBURE DE SILICIUM POLYCRISTALLIN ET UNE COUCHE ACTIVE DE CARBURE DE SILICIUM MONOCRISTALLIN**
VERFAHREN ZUR HERSTELLUNG EINER HALBLEITERSTRUKTUR MIT EINEM POLYKRISTALLINEN SILICIUMCARBIDSUBSTRAT UND EINER AKTIVEN SCHICHT AUS EINKRISTALLINEM SILICIUMCARBID
PROCESS FOR THE MANUFACTURE OF A SEMICONDUCTOR STRUCTURE COMPRISING A POLYCRYSTALLINE SILICON CARBIDE SUBSTRATE AND AN ACTIVE LAYER OF SINGLE-CRYSTAL SILICON CARBIDE

(30) Priorité: 14.12.2021 FR 2113508
(43) Date de publication de la demande: 23.10.2024
(73) Titulaire: SOITEC, 38190 Bernin (FR)
(72) Inventeur: BIARD, Hugo, 38190 BERNIN (FR); GUIOT, Eric, 38190 BERNIN (FR)
(74) Mandataire: Regimbeau
(86) Numéro de dépôt international: PCT/FR2022/052331
(87) Numéro de publication internationale: WO 2023/111446

(56) Documents cités:
- WO-A1-2014/002576
- WO-A1-2021/060516
- WO-A1-2021/191512
- US-A1- 2018 251 911
- US-A1- 2020 006 493
- US-B2- 10 934 634

## Description

### DOMAINE TECHNIQUE

L'invention concerne un procédé de fabrication d'une structure semi-conductrice comprenant un substrat support de carbure de silicium polycristallin et une couche active de carbure de silicium monocristallin, ainsi qu'une telle structure et un dispositif électronique comprenant une telle structure, notamment pour des applications de puissance ou des applications radiofréquence.

### ETAT DE LA TECHNIQUE

Le carbure de silicium (SiC) est un matériau d'intérêt dans la microélectronique, en particulier pour la fabrication de substrats pour des dispositifs électroniques destinés à des applications de puissance.

Ces dispositifs microélectroniques comprennent une couche active de SiC monocristallin, dans ou sur laquelle sont formés des transistors et d'autres composants électroniques adaptés pour remplir les fonctions requises.

La couche active est agencée sur un substrat support de SiC polycristallin dopé pour présenter une bonne conductivité électrique. En effet, dans ces dispositifs, le courant électrique appliqué aux transistors et autres composants électriques de la couche active passe au travers du substrat, en direction de sa face arrière, qui est la face opposée à la couche active.

La formation d'une structure semi-conductrice comprenant la couche active et le substrat support peut être effectuée par le procédé Smart Cut^{™}. Selon ce procédé, on forme, par implantation d'espèces atomiques dans un substrat donneur de SiC monocristallin, une zone de fragilisation délimitant la couche active, on colle le substrat donneur sur un substrat support de SiC polycristallin, puis on détache le substrat donneur le long de la zone de fragilisation de sorte à transférer la couche active sur le substrat support. Le détachement peut être initié par une action mécanique, un traitement thermique ou tout autre moyen adapté, lesdits moyens pouvant éventuellement être combinés.

Le SiC présente plusieurs polytypes, c'est-à-dire des structures cristallines différentes. Les principaux polytypes utilisés dans le domaine de la microélectronique sont le polytype 3C, de structure cubique, et les polytypes 4H et 6H, de structure hexagonale. Ces polytypes diffèrent notamment par leur paramètre de maille, par leurs diagrammes de bandes électroniques et par leur coefficient de dilatation thermique.

En général, les substrats de SiC polycristallin sont disponibles commercialement sous la forme 3C. En effet, ce polytype peut être obtenu par dépôt chimique en phase vapeur sur un substrat germe, généralement en graphite, à une température relativement basse, c'est-à-dire typiquement inférieure ou égale à 1400°C, de sorte que le procédé de fabrication est relativement économe en énergie.

En revanche, les substrats de SiC monocristallin sont disponibles commercialement, dans des dimensions utiles dans l'industrie, c'est-à-dire typiquement de l'ordre de 150 à 200 mm de diamètre, avec une structure hexagonale, de type 4H ou 6H.

Par conséquent, l'assemblage d'une couche active de SiC polycristallin de type 4H et d'un substrat support de SiC polycristallin implique la formation d'une interface présentant deux types de discontinuités : une discontinuité en termes de qualité cristalline (monocristalline / polycristalline) et une discontinuité en termes de structure cristalline (hexagonale / cubique).

Ces deux discontinuités sont susceptibles de générer plusieurs problèmes affectant les performances de la structure.

D'une part, la différence de coefficient de dilatation thermique peut générer une déformation de la structure lorsque celle-ci est soumise à un budget thermique élevé.

Un tel budget thermique peut être appliqué à la structure à l'occasion d'un recuit destiné à renforcer l'interface de collage. En effet, les procédés connus ne permettent pas un collage direct du substrat donneur sur le substrat support, et requièrent l'utilisation d'une couche de collage, par exemple en silicium dopé. Le collage est alors fréquemment suivi d'un recuit de stabilisation réalisé à une température de l'ordre de 1700°C.

Un budget thermique élevé, typiquement entre 1500 et 2000°C, peut également être appliqué lors d'une phase ultérieure de fabrication du dispositif électronique, par exemple lorsqu'une épitaxie est réalisée sur la couche active pour former d'autres parties du dispositif électronique, ou lors d'un traitement thermique d'activation de dopants.

La déformation due à la différence de coefficient de dilatation thermique peut dégrader la planéité de la structure, qui est préjudiciable à la mise en oeuvre des étapes ultérieures de fabrication du dispositif électronique, et réduire la tenue mécanique du collage.

D'autre part, la différence de qualité cristalline, qui ne permet pas un alignement des grains cristallins de part et d'autre de l'interface de collage, peut engendrer une perte de conductivité électrique à l'interface.

Le document US 2020/006493 A1 décrit un substrat support en SiC polycristallin et précise que le matériau du substrat support ne se limite pas à un SiC polycristallin de type 3C, et que divers SiC polycristallins peuvent être utilisés.

Le document WO 2014/002576 A1 décrit qu'un SiC polycristallin de type 4H ou un mélange de différents polytypes 4H, 6H et 3C peut être utilisé comme matériau pour le substrat support.

### BREVE DESCRIPTION DE L'INVENTION

Un but de l'invention est de concevoir un procédé de fabrication d'une structure semi-conductrice comprenant une couche active de SiC monocristallin sur un substrat support de SiC polycristallin, qui permette de minimiser les inconvénients liés à la différence de qualité cristalline et de polytype à l'interface entre la couche active et le substrat support.

A cet effet, l'invention propose un procédé de fabrication d'une structure semi-conductrice comprenant un substrat support de carbure de silicium (SiC) polycristallin et une couche active de carbure de silicium monocristallin, comprenant :
- la formation d'un substrat support comprenant un empilement d'une première couche de SiC polycristallin principalement du polytype 3C et d'une seconde couche de SiC polycristallin principalement du polytype 4H et/ou 6H,
- le collage d'un substrat donneur comprenant une couche active de SiC monocristallin du polytype 4H ou 6H sur une face du polytype 4H et/ou 6H du substrat support,
- le transfert de la couche active sur le substrat support.

Ainsi, on a dissocié dans la structure finale l'interface entre les couches de qualités cristallines différentes (qui reste à l'interface de collage entre la couche active et le substrat support), et l'interface entre les couches de polytypes différents (qui est enterrée dans le substrat support, à distance de l'interface de collage).

Dans le présent texte, le terme « principalement du polytype 3C » signifie que la proportion volumique de grains de structure 3C dans la première couche est supérieure ou égale à 60%, de préférence supérieure ou égale à 70%, voire supérieure ou égale à 80%. De même, l'expression « principalement du polytype 4H et/ou 6H » signifie que la proportion volumique de grains de structure 4H et/ou 6H dans la seconde couche est supérieure ou égale à 60%, de préférence supérieure ou égale à 70%, et de manière encore préférée supérieure ou égale à 80%.

Dans le présent texte, les termes « première » et « seconde » désignent les deux couches de SiC polycristallin de polytypes différents du substrat support, sans induire un ordre particulier de formation desdites couches.

Ainsi, dans certains modes de réalisation, on fait croître la première couche sur un substrat germe puis on fait croître la seconde couche sur la première couche, de sorte que le substrat support présente directement une surface libre principalement du polytype 4H et/ou 6H pour le collage du substrat donneur.

Dans d'autres modes de réalisation, on fait croître la seconde couche sur un substrat germe, puis on fait croître la première couche sur la seconde couche. Dans ce cas, pour permettre le collage du substrat donneur sur une face principalement du polytype 4H et/ou 6H du substrat support, on retire le substrat germe afin de libérer la face de la seconde couche située du côté du substrat germe.

Selon d'autres caractéristiques avantageuses mais optionnelles, éventuellement combinées lorsque cela est techniquement pertinent :
- la formation du substrat support comprend la croissance de la première couche sur un substrat germe puis la croissance de la seconde couche sur la première couche ;
- la formation du substrat support comprend successivement la croissance de la seconde couche sur un substrat germe, la croissance de la première couche sur la seconde couche, et le retrait du substrat germe pour exposer une face de la seconde couche pour le collage du substrat donneur ;
- le substrat germe est un substrat de SiC monocristallin ou polycristallin principalement du polytype 4H et/ou 6H ;
- on fait croître la première couche sur une épaisseur comprise entre 1 et 20 µm, et on fait croître la seconde couche sur une épaisseur comprise entre 80 et 350 µm ;
- on fait croître la première couche sur une épaisseur comprise entre 80 et 200 µm, et on fait croître la seconde couche sur une épaisseur comprise entre 150 et 270 µm ;
- la croissance de la première et de la seconde couche est réalisée par dépôt chimique en phase vapeur (CVD) ;
- la croissance de la première couche est mise en oeuvre à une température comprise entre 1100 et 1500°C, de préférence entre 1200 et 1400°C ;
- la croissance de la seconde couche est mise en oeuvre à une température comprise entre 1500 et 2600°C, de préférence comprise entre 1700 et 1900°C ou entre 1800 et 2400°C, voire comprise entre 2000 et 2250°C ;
- le procédé comprend en outre l'introduction de dopants pendant la croissance de la première et de la seconde couche ;
- le substrat donneur est collé directement sur la face du polytype 4H et/ou 6H du substrat support ;
- le substrat donneur est collé sur la face du polytype 4H et/ou 6H du substrat support par l'intermédiaire d'une couche de collage ;
- la couche de collage comprend du silicium ou du tungstène ;
- le procédé comprend, avant le collage, une étape d'implantation d'espèces atomiques dans le substrat donneur pour former une zone de fragilisation délimitant la couche active et, après le collage, une étape de détachement du substrat donneur le long de la zone de fragilisation pour transférer la couche active sur le substrat support ;
- dans le cas où l'on fait croître la première couche sur une épaisseur comprise entre 1 et 20 µm, on procède, après le transfert de la couche active sur le substrat support, au retrait de la première couche.

Un autre objet de l'invention concerne une structure semi-conductrice comprenant successivement, de sa face arrière vers sa face avant :
- une première couche de SiC polycristallin principalement du polytype 3C,
- une seconde couche de SiC polycristallin principalement du polytype 4H et/ou 6H,
- une couche active de SiC monocristallin du polytype 4H ou 6H.

Dans le présent texte, le terme « successivement » spécifie un ordre spatial des couches mais n'induit pas nécessairement un contact direct entre lesdites couches.

Dans certains modes de réalisation, la première couche présente une épaisseur comprise entre 80 et 350 µm et la seconde couche présente une épaisseur comprise entre 1 et 20 µm.

Dans d'autres modes de réalisation, la première couche présente une épaisseur comprise entre 80 et 200 µm et la seconde couche présente une épaisseur comprise entre 150 et 270 µm.

Un autre objet de l'invention concerne un dispositif électronique, notamment pour applications de puissance ou applications radiofréquence, comprenant une structure telle que décrite ci-dessus et au moins un composant électronique, tel qu'un un transistor, une diode, un composant électronique de puissance, et/ou un composant électronique radiofréquence, agencé dans ou sur la couche active.

### BREVE DESCRIPTION DES FIGURES

D'autres caractéristiques et avantages de l'invention ressortiront de la description détaillée qui va suivre, en référence aux dessins annexés, sur lesquels :
- la figure 1 représente une vue en coupe d'une structure semi-conductrice selon un premier mode de réalisation ;
- la figure 2 représente une vue en coupe d'une structure selon un deuxième mode de réalisation ;
- les figures 3A à 3D représentent schématiquement des étapes d'un procédé de fabrication de la structure semi-conductrice de la figure 1 ;
- les figures 4A à 4D représentent schématiquement des étapes d'un procédé de fabrication de la structure semi-conductrice de la figure 2 ;
- les figures 5A à 5D représentent schématiquement des étapes d'une variante des procédés des figures 3A-3D et 4A-4D.

Pour des raisons de lisibilité, les dessins ne sont pas nécessairement réalisés à l'échelle.

### DESCRIPTION DETAILLEE DE MODES DE REALISATION

La présente description porte sur une structure semi-conductrice comprenant un substrat support de SiC polycristallin et une couche active de SiC monocristallin s'étendant sur le substrat support.

Le substrat support comprend deux couches de SiC polycristallin de polytypes différents : une première couche principalement du polytype 3C et une seconde couche principalement du polytype 4H et/ou 6H.

La première et la seconde couche de SiC polycristallin peuvent se présenter selon différentes configurations dans la structure, qui seront décrites plus bas.

La couche active est réalisée en SiC monocristallin pour présenter des propriétés électriques optimales. La couche active présente une structure hexagonale, principalement du polytype 4H ou 6H.

La couche active est rapportée par collage sur le substrat support, sur une face du polytype 4H et/ou 6H. Ce collage peut être direct ou indirect, par l'intermédiaire d'une couche de collage.

On notera que la couche active est collée sur une couche de SiC polycristallin d'un polytype qui est également hexagonal. Ainsi, les matériaux présents à l'interface de collage présentent des structures de bandes plus proches que dans le cas d'un collage entre un matériau de structure hexagonale et un matériau de structure cubique, ce qui peut être favorable à une meilleure conductivité électrique au niveau de l'interface. Par ailleurs, cette similitude entre les structures hexagonales présentes à l'interface permet de réduire la différence de coefficient de dilatation thermique de part et d'autre de l'interface. De ce fait, on peut éviter les risques de déformation plastique durant les étapes de fabrication à haute température, ainsi que les défauts de focalisation dus à des courbures de la structure lors des étapes de lithographie mises en oeuvre ultérieurement pour la fabrication de dispositifs électroniques.

Quel que soit l'agencement de la première et de la seconde couche de SiC polycristallin formant le substrat support, deux interfaces de natures différentes sont présentes au sein de ladite structure.

Une première interface est l'interface entre la couche active monocristalline et le substrat support polycristallin, qui est une interface entre des couches de qualités cristallines différentes mais de polytypes similaires.

Une seconde interface est l'interface entre la première et la seconde couche de SiC polycristallin du substrat support, qui est une interface entre des couches de polytypes différents mais de qualités cristallines similaires. Cette seconde interface est localisée dans l'épaisseur du substrat support et est donc distante de la première interface.

On notera que la seconde interface ne marque pas nécessairement un passage abrupt du polytype cubique au polytype hexagonal, mais peut comprendre une zone de transition présentant une certaine épaisseur, qui peut typiquement aller jusqu'à 20 µm. Cependant, compte tenu de l'épaisseur de la seconde couche, même avec une telle zone de transition, la première interface est suffisamment éloignée de la seconde interface.

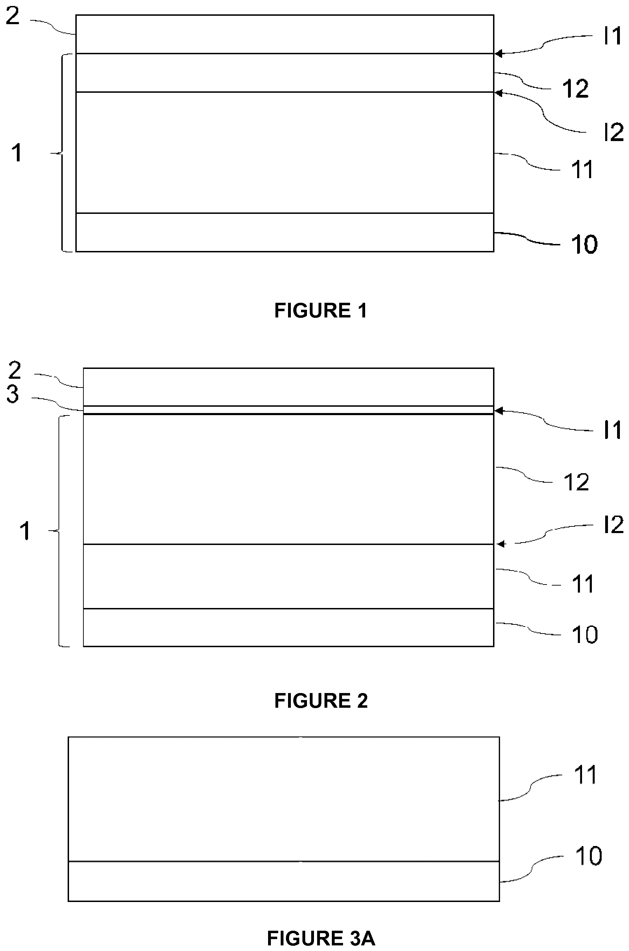

Selon un premier mode de réalisation, illustré sur la figure 1, la structure comprend successivement, de sa face arrière vers sa face avant, un substrat germe 10, la première couche 11 de SiC polycristallin principalement du polytype 3C, la seconde couche 12 de SiC polycristallin principalement du polytype 4H et/ou 6H (le substrat germe et les couches 11 et 12 formant ensemble le substrat support 1) et la couche active 2 de SiC monocristallin du polytype 4H ou 6H.

Comme indiqué plus bas, le substrat germe 10 est utilisé pour la croissance de la première couche 11. Il peut donc être retiré de la structure lorsque sa présence n'est plus nécessaire.

Dans ce premier mode de réalisation de la structure, la première couche 11 est sensiblement plus épaisse que la seconde couche 12. Par exemple, la première couche 11 présente une épaisseur comprise entre 80 et 350 µm tandis que la seconde couche 12 présente une épaisseur comprise entre 1 et 20 µm.

Le polytype 3C étant susceptible d'être obtenu à une température plus basse que les polytypes 4H ou 6H, la fabrication de ce premier mode de réalisation de la structure est plus économe en énergie.

A un stade ultérieur de fabrication, une partie arrière de la première couche 11 peut éventuellement être retirée.

Ladite structure présente une première interface I1 entre la couche active 2 qui est monocristalline et le substrat support 1 qui est polycristallin.

Sur la figure 1, la couche active 2 est représentée en contact direct avec la seconde couche de SiC polycristallin 12, mais il serait également possible d'avoir une couche de collage (du type de la couche référencée 3 sur la figure 2) à l'interface entre ces deux couches. Une telle couche de collage peut typiquement être en silicium ou en tungstène, de sorte à favoriser la tenue mécanique du collage tout en assurant une conduction électrique entre la couche active 2 et le substrat support 1.

Par ailleurs, la structure présente une seconde interface I2 entre la première couche 11 qui est principalement du polytype 3C et la seconde couche 12 qui est principalement du polytype 4H et/ou 6H.

Les interfaces I1 et I2 sont donc distantes de l'épaisseur de la seconde couche 12.

Selon un second mode de réalisation, illustré sur la figure 2, la structure comprend successivement, de sa face arrière vers sa face avant, un substrat germe 10, la première couche 11 de SiC polycristallin principalement du polytype 3C, la seconde couche 12 de SiC polycristallin principalement du polytype 4H et/ou 6H (le substrat germe et les couches 11 et 12 formant ensemble le substrat support 1), une couche de collage 3 et la couche active 2 de SiC monocristallin du polytype 4H ou 6H.

Comme indiqué plus bas, le substrat germe 10 est utilisé pour la croissance de la première couche 11. Il peut donc être retiré de la structure lorsque sa présence n'est plus nécessaire.

Dans ce second mode de réalisation de la structure, la première couche 11 est sensiblement plus fine que la seconde couche 12. Par exemple, la première couche 11 présente une épaisseur comprise entre 80 et 200 µm tandis que la seconde couche 12 présente une épaisseur comprise entre 150 et 270 µm. Le fait que la couche de structure cubique soit plus fine permet de limiter les déformations dues à la différence de coefficient de dilatation thermique entre les structures 3C et 4H/6H.

Ladite structure présente une première interface I1 entre la couche active 2 qui est monocristalline et le substrat support 1 qui est polycristallin.

Sur la figure 2, une couche de collage 3 est représentée entre la couche active 2 et la seconde couche de SiC polycristallin 12, mais cette couche de collage est optionnelle et il serait également possible de réaliser un collage direct entre les couches 2 et 12. La couche de collage 3 peut typiquement être en silicium ou en tungstène, de sorte à favoriser la tenue mécanique du collage tout en assurant une conduction électrique entre la couche active 2 et le substrat support 1.

Par ailleurs, la structure présente une seconde interface I2 entre la première couche 11 qui est principalement du polytype 3C et la seconde couche 12 qui est principalement du polytype 4H et/ou 6H.

Les interfaces I1 et I2 sont donc distantes de l'épaisseur de la seconde couche 12.

Eventuellement, à un stade ultérieur du procédé de fabrication, la première couche 11 peut être retirée, auquel cas la seconde interface n'est plus présente dans la structure finale. Cependant, la structure bénéficie toujours de la première interface I1 entre deux couches de structure hexagonale, qui, comme expliqué plus haut, est favorable à la fois du fait d'une différence de coefficients de dilatation thermique réduite et d'une proximité plus grande des structures de bande.

On va maintenant décrire différents procédés de fabrication de ces structures.

Les figures 3A à 3D illustrent de manière schématique les étapes d'un procédé de fabrication de la structure de la figure 1.

En référence à la figure 3A, on forme sur le substrat germe 10 la première couche 11 de SiC polycristallin principalement du polytype 3C. Le substrat germe 10 est typiquement un substrat de graphite, mais tout autre matériau dont le coefficient de dilatation thermique est proche de celui du SiC polycristallin et, qui présente de préférence un faible coût et/ou est réutilisable, peut être employé. Des matériaux alternatifs au graphite sont ainsi le SiC polycristallin fritté et le SiC monocristallin (liste non limitative).

La première couche 11 peut être formée par dépôt chimique en phase vapeur (CVD, acronyme du terme anglo-saxon « Chemical Vapor Deposition »). Ce dépôt peut faire intervenir les précurseurs suivants (exemples non limitatifs) :
- pour le carbone : éthane, propane, ou acétylène ;
- pour le silicium : silane, tétrachlorosilane, trichlorosilane, ou dichlorosilane ;
- ou encore du tétraméthylsilane comme source commune de carbone et de silicium.

Ces précurseurs sont portés par un gaz vecteur qui pourra être choisi par l'azote, l'argon, l'hélium et le dihydrogène.

L'homme du métier est à même de définir les paramètres de dépôt, notamment la température, en fonction des précurseurs utilisés et de l'installation utilisée pour effectuer le dépôt.

Pour obtenir une structure cubique, une température de dépôt relativement basse est utilisée, typiquement comprise entre 1100 et 1500°C, de préférence entre 1200 et 1400°C. On fait croître ladite première couche 11 sur une épaisseur comprise entre 80 et 350 µm. La croissance s'effectue généralement sur les deux faces du substrat germe, de sorte qu'une couche de SiC polycristallin principalement du polytype 3C se forme également sur la face arrière du substrat germe. Cette couche n'étant pas destinée à être conservée dans la structure, elle n'a pas été représentée dans un souci de simplification des dessins.

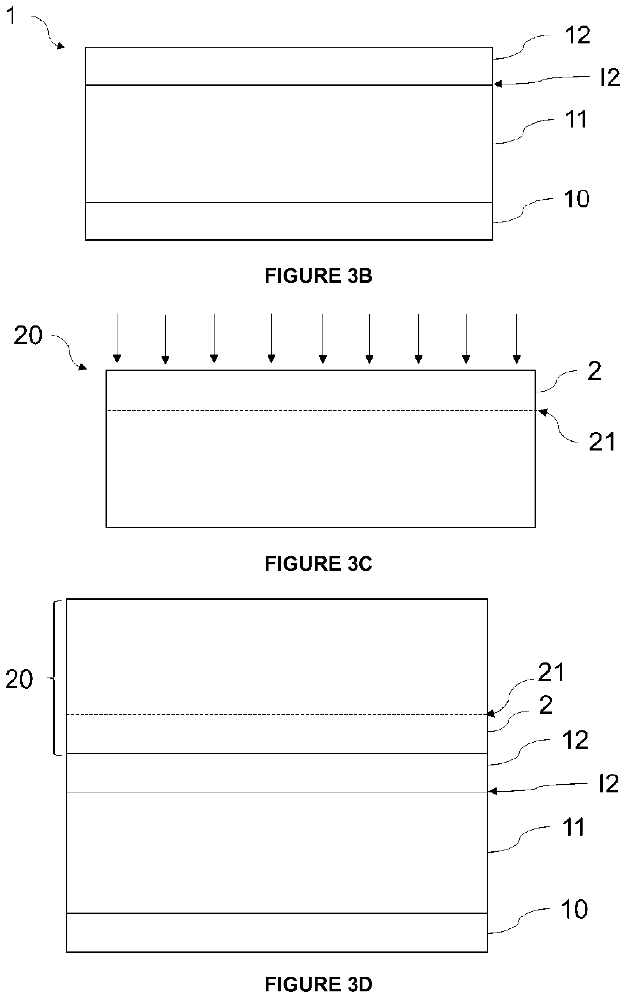

En référence à la figure 3B, on forme la seconde couche 12 de SiC polycristallin, principalement du polytype 4H et/ou 6H, sur la première couche 11, pour obtenir le substrat support 1. La seconde couche 12 peut également être formée par dépôt chimique en phase vapeur mais, pour obtenir une structure hexagonale, une température de dépôt relativement élevée est utilisée, typiquement comprise entre 1500 et 2600°C, de préférence comprise entre 1700 et 1900°C ou entre 1800 et 2400°C, voire entre 2000 et 2250°C. La température de croissance dépend en particulier de la technique de dépôt, des précurseurs utilisés et des autres conditions opératoires et est donc donnée uniquement à titre indicatif, l'homme du métier étant à même de définir un procédé de croissance adapté au polytype souhaité. Les précurseurs peuvent être choisis parmi la même liste que celle présentée plus haut pour le dépôt de la première couche.

Outre le dépôt chimique en phase vapeur précédemment mentionné, la seconde couche peut être formée par dépôt chimique en phase vapeur à haute température (HTCVD, acronyme du terme anglo-saxon « High Temperature Chemical Vapor Deposition), par croissance en phase liquide (technique connue sous l'acronyme TSSG du terme anglo-saxon « Top Seeded Solution Growth », ou encore par dépôt physique en phase vapeur (PVD ou PVT).

Bien que la mise en oeuvre du dépôt à une telle température nécessite une énergie très élevée, le fait que la seconde couche soit formée sur une faible épaisseur (comprise entre 1 µm et 20 µm) permet de limiter la consommation énergétique globale et le coût du procédé. Le dépôt de la seconde couche est avantageusement réalisé dans le même bâti que la première couche, dans lequel on augmente la température de dépôt pour modifier le polytype du SiC déposé.

Selon une variante envisageable, la première couche 11 est formée par un procédé de frittage avant d'être transférée dans une chambre de dépôt dans laquelle la seconde couche 12 est ensuite déposée sur la première couche 11 par l'une des techniques de dépôt ou croissance mentionnées précédemment.

La transition entre la structure cubique de la première couche et la structure hexagonale de la seconde couche de SiC polycristallin peut ne pas être franche mais présenter une zone de transition comprenant un mélange de grains de type 3C et de grains de type 4H et/ou 6H, sur une épaisseur pouvant aller jusqu'à 20 µm. Cependant, dans la mesure où cette zone de transition est distante de l'interface de collage entre la couche active et le substrat support, elle n'est pas préjudiciable aux performances de la structure.

De préférence, la première et la seconde couche sont dopées par introduction de dopants au cours de leur croissance, selon une technique connue. Les dopants peuvent être typiquement de l'azote, du bore, du phosphore ou de l'aluminium, selon le type de dopage souhaité. La teneur en dopants est généralement comprise entre 10¹⁸ et 10²¹ at/cm³.

En référence à la figure 3C, on fournit un substrat donneur 20 dans lequel on forme par implantation d'espèces atomiques (typiquement de l'hydrogène et/ou de l'hélium) une zone de fragilisation 21 délimitant la couche active 2 à transférer. Le substrat donneur 20 est un substrat de SiC monocristallin de polytype 4H ou 6H, disponible commercialement dans une dimension adaptée, typiquement de l'ordre de 150 à 200 mm de diamètre.

En référence à la figure 3D, on colle le substrat donneur 20 sur le substrat support 1. Au préalable, en vue d'un collage direct des deux substrats, on applique tout traitement de surface adapté pour s'assurer que les surfaces en contact soient aussi peu rugueuses que possible, c'est-à-dire notamment présentent une rugosité inférieure à 1 nm RMS, de préférence inférieure à 0,5 nm RMS, et de manière encore préférée inférieure à 0,2 nm RMS. Par ailleurs, les surfaces sont avantageusement rendues hydrophobes.

Ensuite, on détache le substrat donneur le long de la zone de fragilisation 21 de sorte à transférer la couche active 2 sur le substrat support 1 et obtenir la structure de la figure 1.

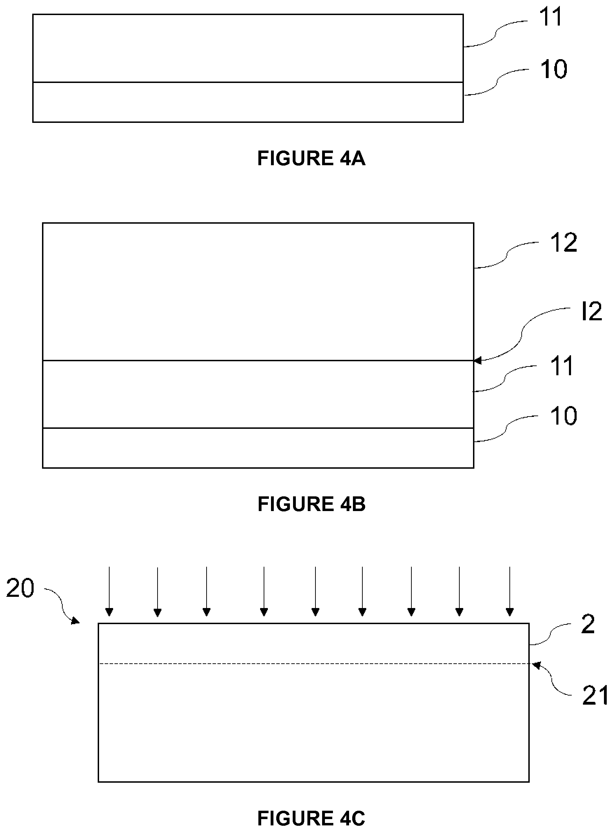

Les figures 4A à 4D illustrent de manière schématique les étapes d'un procédé de fabrication de la structure de la figure 2.

En référence à la figure 4A, on forme sur le substrat germe 10 la première couche 11 de SiC polycristallin principalement du polytype 3C. Le substrat germe 10 est typiquement un substrat de graphite. La première couche 11 est formée par dépôt chimique en phase vapeur (CVD, acronyme du terme anglo-saxon « Chemical Vapor Deposition »). Pour obtenir une structure cubique, une température de dépôt relativement basse est utilisée, typiquement comprise entre 1100 et 1500°C, de préférence entre 1200 et 1400°C. On fait croître ladite première couche 11 sur une épaisseur comprise entre 1 et 20 µm.

En référence à la figure 4B, on forme la seconde couche 12 de SiC polycristallin, principalement du polytype 4H et/ou 6H, sur la première couche 11, pour obtenir le substrat support 1. La seconde couche 12 est également formée par dépôt chimique en phase vapeur mais, pour obtenir une structure hexagonale, une température de dépôt relativement élevée est utilisée, typiquement comprise entre 1500 et 2600°C, de préférence comprise entre 1700 et 1900°C ou entre 1800 et 2400°C, voire comprise entre 2000 et 2250°C. Comme indiqué plus haut, l'homme du métier est à même de déterminer les conditions de croissance pour le polytype souhaité en fonction de la technique employée et des précurseurs utilisés. La seconde couche est formée sur une épaisseur comprise entre 80 et 350 µm. Le dépôt de la seconde couche est avantageusement réalisé dans le même bâti que la première couche, dans lequel on augmente la température de dépôt pour modifier le polytype du SiC déposé.

Comme indiqué plus haut, la transition entre la structure cubique de la première couche et la structure hexagonale de la seconde couche de SiC polycristallin peut ne pas être franche mais présenter une zone de transition comprenant un mélange de grains de type 3C et de grains de type 4H et/ou 6H.

De préférence, la première et la seconde couche sont dopées par introduction de dopants au cours de leur croissance, selon une technique connue. Les dopants peuvent être typiquement de l'azote, du bore, du phosphore ou de l'aluminium, selon le type de dopage souhaité. La teneur en dopants est généralement comprise entre 10¹⁸ et 10²¹ at/cm³.

En référence à la figure 4C, on fournit un substrat donneur 20 dans lequel on forme par implantation d'espèces atomiques (typiquement de l'hydrogène et/ou de l'hélium) une zone de fragilisation 21 délimitant la couche active 2 à transférer. Le substrat donneur 20 est un substrat de SiC monocristallin de polytype 4H ou 6H, disponible commercialement dans une dimension adaptée, typiquement de l'ordre de 150 à 200 mm de diamètre.

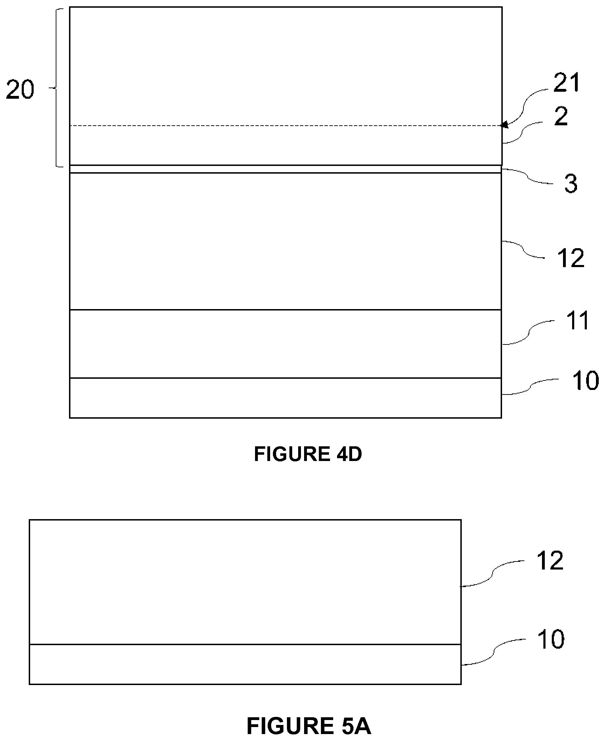

En référence à la figure 4D, on colle le substrat donneur 20 sur le substrat support 1 par l'intermédiaire de la couche de collage 3. La couche de collage 3 peut être déposée au préalable soit sur le substrat donneur 20, soit sur la seconde couche 12 du substrat support 1. Pour favoriser une bonne tenue du collage, un traitement préalable des surfaces à coller peut être mis en oeuvre de sorte à obtenir une rugosité très faible, typiquement inférieure à 1 nm RMS, de préférence inférieure à 0,5 nm RMS.

Ensuite, on détache le substrat donneur le long de la zone de fragilisation 21 de sorte à transférer la couche active 2 sur le substrat support 1 et obtenir la structure de la figure 2.

Dans le cas où la seconde couche (polytype 4H et/ou 6H) est suffisamment épaisse, c'est-à-dire qu'elle présente une épaisseur supérieure ou égale à 100 µm, il est possible de retirer la première couche (polytype 3C), notamment après la formation d'un composant électronique dans la couche active. Ce retrait de la première couche peut être réalisé par meulage ou tout autre moyen. Il permet d'exposer, sur la face arrière de la structure, une surface du polytype 4H et/ou 6H, sur laquelle un contact électrique peut être ensuite déposé dans les cas où la géométrie du composant exige un contact en face arrière.

Ce retrait permet de diminuer la résistance électrique totale de la structure, puisqu'un des contacts est en face arrière et que le courant électrique a donc moins de matériau à traverser entre le composant en face avant et le contact en face arrière. De manière générale, il est fréquemment prévu de modifier l'épaisseur de la structure semi-conductrice en retirant une partie du substrat, par exemple pour l'adapter aux dimensions des outils devant utiliser ou modifier la structure ou pour adapter les propriétés de celle-ci à son application spécifique

Ainsi, on obtient une structure finale qui est entièrement du polytype 4H et/ou 6H et qui présente donc une plus grande homogénéité en termes de coefficient de dilatation thermique et de propriétés mécaniques, mais dans laquelle le début de la croissance du SiC polycristallin, qu'il est prévu de retirer comme mentionné précédemment et qui peut parfois être de moins bonne qualité cristalline du fait de la croissance granulaire du SiC polycristallin, est fait à la température plus basse de croissance du polytype 3C et est donc plus économe en énergie.

Les procédés décrits ci-dessus sont basés sur la croissance successive, sur un substrat germe, de la première couche de SiC polycristallin principalement du polytype 3C puis de la seconde couche de SiC polycristallin principalement du polytype 4H et/ou 6H.

De manière alternative, on peut faire croître d'abord la seconde couche de SiC polycristallin principalement du polytype 4H et/ou 6H sur un substrat germe, puis la première couche de SiC polycristallin principalement du polytype 3C sur la seconde couche. Pour transférer la couche active monocristalline de type 4H ou 6H sur une surface du polytype 4H et/ou 6H (qui, comme indiqué plus haut, est plus favorable du fait de la proximité des coefficients de dilatation thermique et des structures de bandes), il est alors nécessaire de retirer le substrat germe pour exposer la face de la seconde couche de SiC polycristallin, et d'inverser le substrat support pour coller le substrat donneur sur ladite seconde couche.

Cette variante est illustrée sur les figures 5A à 5D. Ce procédé peut être utilisé pour former la structure semi-conductrice de la figure 1 ou la structure semi-conductrice de la figure 2.

En référence à la figure 5A, on forme sur le substrat germe 10 la seconde couche 12 de SiC polycristallin principalement du polytype 4H et/ou 6H. Pour favoriser la qualité de la structure hexagonale de la couche 12, le substrat germe 10 est de préférence un substrat de SiC monocristallin ou polycristallin principalement du polytype 4H et/ou 6H. La seconde couche 12 est formée par dépôt chimique en phase vapeur avec une température de dépôt relativement élevée est utilisée, typiquement comprise entre 1500 et 2600°C, de préférence comprise entre 1700 et 1900°C ou entre 1800 et 2400°C, voire entre 2000 et 2250°C. Comme indiqué plus haut, l'homme du métier est à même de déterminer les conditions de croissance pour le polytype souhaité en fonction de la technique employée et des précurseurs utilisés.

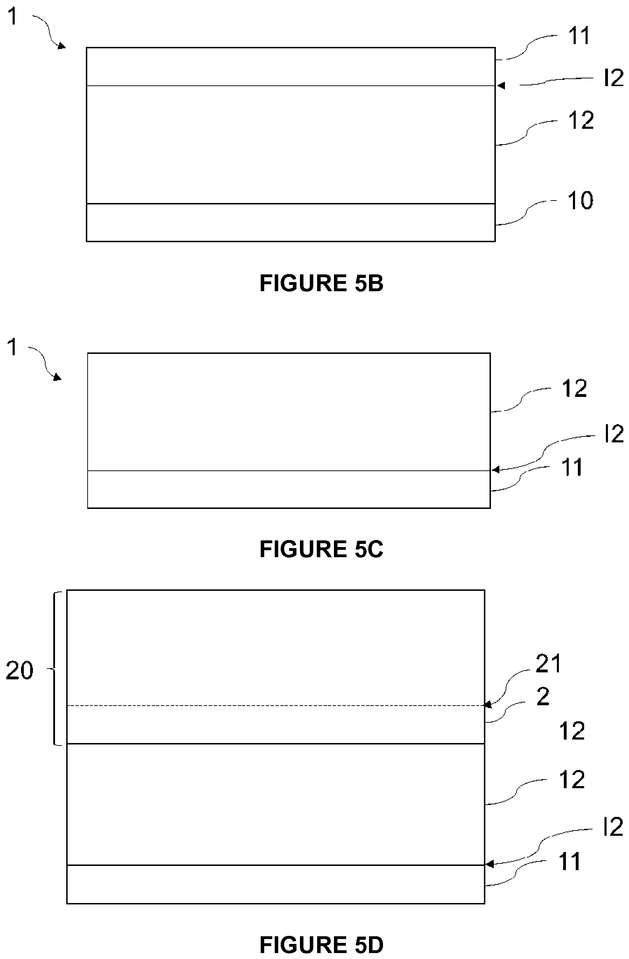

En référence à la figure 5B, on forme sur la seconde couche 12 la première couche 11 de SiC polycristallin principalement du polytype 3C. La première couche 11 est formée par dépôt chimique en phase vapeur à une température de dépôt relativement basse, typiquement comprise entre 1100 et 1500°C, de préférence entre 1200 et 1400°C. Le dépôt de la première couche est avantageusement réalisé dans le même bâti que celui de la seconde couche, en abaissant la température de dépôt pour favoriser un changement de polytype du SiC déposé.

De préférence, la première et la seconde couche sont dopées par introduction de dopants au cours de leur croissance, selon une technique connue. Les dopants peuvent être typiquement de l'azote, du bore, du phosphore ou de l'aluminium, selon le type de dopage souhaité. La teneur en dopants est généralement comprise entre 10¹⁸ et 10²¹ at/cm³.

En référence à la figure 5C, on retire le substrat germe 10 de sorte à exposer la face arrière de la seconde couche 12, qui est principalement du polytype 4H et/ou 6H. Le substrat support 1 est donc constitué uniquement des couches 11 et 12.

Comme dans les autres formes d'exécution du procédé (cf. figures 3C et 4C), on fournit par ailleurs un substrat donneur 20 dans lequel on forme par implantation d'espèces atomiques (typiquement de l'hydrogène et/ou de l'hélium) une zone de fragilisation 21 délimitant la couche active 2 à transférer. Le substrat donneur 20 est un substrat de SiC monocristallin de polytype 4H ou 6H, disponible commercialement dans une dimension adaptée, typiquement de l'ordre de 150 à 200 mm de diamètre.

En référence à la figure 5D, on colle le substrat donneur 20 sur le substrat support 1 soit directement soit par l'intermédiaire de la couche de collage décrite plus haut. A cet effet, le substrat support est inversé pour que la seconde couche 12, qui était du côté arrière lors de la fabrication du substrat support, soit orientée vers l'avant pour recevoir le substrat donneur 20.

Ensuite, on détache le substrat donneur le long de la zone de fragilisation 21 de sorte à transférer la couche active 2 sur le substrat support 1 et obtenir une structure semi-conductrice similaire à celle des figures 1 et 2, dans laquelle le substrat support 1 est dépourvu du substrat germe 10.

La structure semi-conductrice obtenue peut avantageusement être utilisée pour la fabrication de dispositifs électroniques pour des applications de puissance et/ou des applications radiofréquence.

A cet effet, on peut former par reprise d'épitaxie sur la couche active une ou plusieurs couches semi-conductrices supplémentaires, destinée à la formation de composants électroniques.

Par exemple, les composants électroniques formés dans ou sur la couche active peuvent comprendre : un ou plusieurs transistors, une ou plusieurs diodes, un ou plusieurs composants de puissance, un ou plusieurs composants radiofréquence (liste non limitative). Un composant radiofréquence comprend typiquement une ligne de transmission d'un signal électrique radiofréquence et optionnellement un ou plusieurs transistors. Un composant de puissance est défini comme étant un composant adapté pour transporter un courant électrique présentant une puissance de 50 W ou plus.

## Revendications

1. Procédé de fabrication d'une structure semi-conductrice comprenant un substrat support (1) de carbure de silicium (SiC) polycristallin et une couche active (2) de carbure de silicium monocristallin, comprenant :
- la formation d'un substrat support comprenant un empilement d'une première couche (11) de SiC polycristallin principalement du polytype 3C et d'une seconde couche (12) de SiC polycristallin principalement du polytype 4H et/ou 6H,
- le collage d'un substrat donneur (20) comprenant une couche active (2) de SiC monocristallin du polytype 4H ou 6H sur une face du polytype 4H et/ou 6H du substrat support,
- le transfert de la couche active (2) sur le substrat support.

2. Procédé selon la revendication 1, dans lequel la formation du substrat support comprend la croissance de la première couche (11) sur un substrat germe (10) puis la croissance de la seconde couche (12) sur la première couche (11).

3. Procédé selon la revendication 1, dans lequel la formation du substrat support comprend successivement la croissance de la seconde couche (12) sur un substrat germe (10), la croissance de la première couche (11) sur la seconde couche (12), et le retrait du substrat germe (10) pour exposer une face de la seconde couche (12) pour le collage du substrat donneur.

4. Procédé selon la revendication 3, dans lequel le substrat germe (10) est un substrat de SiC monocristallin ou polycristallin principalement du polytype 4H et/ou 6H.

5. Procédé selon l'une des revendications 2 à 4, dans lequel on fait croître la première couche (11) sur une épaisseur comprise entre 1 et 20 µm, et on fait croître la seconde couche (12) sur une épaisseur comprise entre 80 et 350 µm.

6. Procédé selon l'une des revendications 2 à 4, dans lequel on fait croître la première couche (11) sur une épaisseur comprise entre 80 et 200 µm, et on fait croître la seconde couche (12) sur une épaisseur comprise entre 150 et 270 µm.

7. Procédé selon l'une des revendications 2 à 6, dans lequel la croissance de la première et de la seconde couche est réalisée par dépôt chimique en phase vapeur (CVD).

8. Procédé selon l'une des revendications 2 à 7, dans lequel la croissance de la première couche (11) est mise en oeuvre à une température comprise entre 1100 et 1500°C, de préférence entre 1200 et 1400°C.

9. Procédé selon l'une des revendications 2 à 8, dans lequel la croissance de la seconde couche (12) est mise en oeuvre à une température comprise entre 1500 et 2600°C, de préférence comprise entre 1700 et 1900°C ou entre 1800 et 2400°C, voire comprise entre 2000 et 2250°C.

10. Procédé selon l'une des revendications 2 à 9, comprenant en outre l'introduction de dopants pendant la croissance de la première et de la seconde couche.

11. Procédé selon l'une des revendications 1 à 10, dans lequel le substrat donneur (20) est collé directement sur la face du polytype 4H et/ou 6H du substrat support.

12. Procédé selon l'une des revendications 1 à 10, dans lequel le substrat donneur (20) est collé sur la face du polytype 4H et/ou 6H du substrat support par l'intermédiaire d'une couche de collage (3).

13. Procédé selon la revendication 12, dans lequel la couche de collage (3) comprend du silicium ou du tungstène.

14. Procédé selon l'une des revendications 1 à 13, comprenant en outre, avant le collage, une étape d'implantation d'espèces atomiques dans le substrat donneur (20) pour former une zone de fragilisation (21) délimitant la couche active (2) et, après le collage, une étape de détachement du substrat donneur (20) le long de la zone de fragilisation (21) pour transférer la couche active (2) sur le substrat support.

15. Procédé selon l'une des revendications 1 à 14 en combinaison avec la revendication 5, comprenant en outre, après le transfert de la couche active sur le substrat support, le retrait de la première couche (11).

16. Structure semi-conductrice comprenant successivement, de sa face arrière vers sa face avant :
- une première couche (11) de SiC polycristallin principalement du polytype 3C,
- une seconde couche (12) de SiC polycristallin principalement du polytype 4H et/ou 6H,
- une couche active (2) de SiC monocristallin du polytype 4H ou 6H.

17. Structure selon la revendication 16, dans laquelle :
- la première couche (11) présente une épaisseur comprise entre 80 et 350 µm,
- la seconde couche (12) présente une épaisseur comprise entre 1 et 20 µm.

18. Structure selon la revendication 16, dans laquelle :
- la première couche (11) présente une épaisseur comprise entre 80 et 200 µm,
- la seconde couche (12) présente une épaisseur comprise entre 150 et 270 µm.

19. Dispositif électronique, notamment pour applications de puissance ou applications radiofréquence, comprenant la structure selon l'une des revendications 16 à 18 et au moins un composant électronique, tel qu'un un transistor, une diode, un composant électronique de puissance, et/ou un composant électronique radiofréquence, agencé dans ou sur la couche active (2).

## Patentansprüche

1. Verfahren zur Herstellung einer Halbleiterstruktur, die ein Trägersubstrat (1) aus polykristallinem Siliziumkarbid (SiC) und eine aktive Schicht (2) aus monokristallinem Siliziumkarbid umfasst, umfassend:
- das Bilden eines Trägersubstrats, das einen Stapel aus einer ersten Schicht (11) aus polykristallinem SiC, hauptsächlich vom Polytyp 3C, und einer zweiten Schicht (12) aus polykristallinem SiC, hauptsächlich vom Polytyp 4H und/oder 6H, umfasst,
- das Aufkleben eines Donorsubstrats (20), das eine aktive Schicht (2) aus monokristallinem SiC vom Polytyp 4H oder 6H umfasst, auf eine Seite des Polytyps 4H und/oder 6H des Trägersubstrats,
- das Übertragen der aktiven Schicht (2) auf das Trägersubstrat.

2. Verfahren nach Anspruch 1, wobei das Bilden des Trägersubstrats das Aufwachsen der ersten Schicht (11) auf einem Keimsubstrat (10) und anschließend das Aufwachsen der zweiten Schicht (12) auf der ersten Schicht (11) umfasst.

3. Verfahren nach Anspruch 1, wobei das Bilden des Trägersubstrats nacheinander das Aufwachsen der zweiten Schicht (12) auf einem Keimsubstrat (10), das Aufwachsen der ersten Schicht (11) auf der zweiten Schicht (12) und das Entfernen des Keimsubstrats (10) umfasst, um eine Seite der zweiten Schicht (12) für das Aufkleben des Donorsubstrats freizulegen.

4. Verfahren nach Anspruch 3, wobei das Keimsubstrat (10) ein monokristallines oder polykristallines SiC-Substrat ist, das hauptsächlich vom Polytyp 4H und/oder 6H ist.

5. Verfahren nach einem der Ansprüche 2 bis 4, wobei die erste Schicht (11) auf eine Dicke zwischen 1 und 20 µm und die zweite Schicht (12) auf eine Dicke zwischen 80 und 350 µm aufgewachsen wird.

6. Verfahren nach einem der Ansprüche 2 bis 4, wobei die erste Schicht (11) auf eine Dicke zwischen 80 und 200 µm und die zweite Schicht (12) auf eine Dicke zwischen 150 und 270 µm aufgewachsen wird.

7. Verfahren nach einem der Ansprüche 2 bis 6, wobei das Aufwachsen der ersten und der zweiten Schicht durch chemische Gasphasenabscheidung (CVD) erfolgt.

8. Verfahren nach einem der Ansprüche 2 bis 7, wobei das Aufwachsen der ersten Schicht (11) bei einer Temperatur zwischen 1100 und 1500°C, vorzugsweise zwischen 1200 und 1400°C, durchgeführt wird.

9. Verfahren nach einem der Ansprüche 2 bis 8, wobei das Aufwachsen der zweiten Schicht (12) bei einer Temperatur zwischen 1500 und 2600°C, vorzugsweise zwischen 1700 und 1900°C oder zwischen 1800 und 2400°C, sogar zwischen 2000 und 2250°C, durchgeführt wird.

10. Verfahren nach einem der Ansprüche 2 bis 9, das ferner das Einbringen von Dotiermitteln während des Aufwachsens der ersten und der zweiten Schicht umfasst.

11. Verfahren nach einem der Ansprüche 1 bis 10, wobei das Donorsubstrat (20) direkt auf die Seite des Polytyps 4H und/oder 6H des Trägersubstrats geklebt wird.

12. Verfahren nach einem der Ansprüche 1 bis 10, wobei das Donorsubstrat (20) anhand einer Klebeschicht (3) auf die Seite des Polytyps 4H und/oder 6H des Trägersubstrats geklebt wird.

13. Verfahren nach Anspruch 12, wobei die Klebeschicht (3) Silizium oder Wolfram umfasst.

14. Verfahren nach einem der Ansprüche 1 bis 13, das ferner vor dem Kleben einen Schritt des Implantierens von atomaren Spezies in das Donorsubstrat (20) umfasst, um eine Schwächungszone (21) zu bilden, die die aktive Schicht (2) begrenzt, und nach dem Aufkleben einen Schritt des Ablösens des Donorsubstrats (20) entlang der Schwächungszone (21), um die aktive Schicht (2) auf das Trägersubstrat zu übertragen.

15. Verfahren nach einem der Ansprüche 1 bis 14 in Kombination mit Anspruch 5, das ferner nach dem Übertragen der aktiven Schicht auf das Trägersubstrat das Entfernen der ersten Schicht (11) umfasst.

16. Halbleiterstruktur, die von ihrer Rückseite zu ihrer Vorderseite hin nacheinander umfasst:
- eine erste Schicht (11) aus polykristallinem SiC, hauptsächlich vom Polytyp 3C,
- eine zweite Schicht (12) aus polykristallinem SiC, hauptsächlich vom Polytyp 4H und/oder 6H,
- eine aktive Schicht (2) aus monokristallinem SiC vom Polytyp 4H oder 6H.

17. Struktur nach Anspruch 16, wobei:
- die erste Schicht (11) eine Dicke zwischen 80 und 350 µm aufweist,
- die zweite Schicht (12) eine Dicke zwischen 1 und 20 µm aufweist.

18. Struktur nach Anspruch 16, wobei:
- die erste Schicht (11) eine Dicke zwischen 80 und 200 µm aufweist,
- die zweite Schicht (12) eine Dicke zwischen 150 und 270 µm aufweist.

19. Elektronische Vorrichtung, insbesondere für Leistungsanwendungen oder Hochfrequenzanwendungen, umfassend die Struktur nach einem der Ansprüche 16 bis 18 und mindestens eine elektronische Komponente wie ein Transistor, eine Diode, eine elektronische Leistungskomponente und/oder eine elektronische Hochfrequenzkomponente, die in oder auf der aktiven Schicht (2) eingerichtet ist.

## Claims

1. A method of manufacturing a semiconductor structure comprising a polycrystalline silicon carbide (SiC) substrate (1) and an active layer (2) of single-crystal silicon carbide, comprising:
- forming a support substrate comprising a stack of a first layer (11) of polycrystalline SiC mainly of the 3C polytype and a second layer (12) of polycrystalline SiC mainly of the 4H and/or 6H polytype,
- bonding a donor substrate (20) comprising an active layer (2) of single-crystal SiC of the 4H or 6H polytype to one face of the 4H and/or 6H polytype of the support substrate,
- transferring the active layer (2) onto the support substrate.

2. Method according to claim 1, wherein the formation of the support substrate comprises the growth of the first layer (11) on a seed substrate (10) and then the growth of the second layer (12) on the first layer (11).

3. Method according to claim 1, wherein the formation of the support substrate comprises successively growing the second layer (12) on a seed substrate (10), growing the first layer (11) on the second layer (12), and removing the seed substrate (10) to expose a face of the second layer (12) for bonding the donor substrate.

4. Method according to claim 3, wherein the seed substrate (10) is a single-crystal or polycrystalline SiC substrate mainly of the 4H and/or 6H polytype.

5. Method according to one of claims 2 to 4, wherein the first layer (11) is grown to a thickness of between 1 and 20 µm, and the second layer (12) is grown to a thickness of between 80 and 350 µm.

6. Method according to one of claims 2 to 4, in which the first layer (11) is grown to a thickness of between 80 and 200 µm, and the second layer (12) is grown to a thickness of between 150 and 270 µm.

7. Method according to one of claims 2 to 6, wherein the growth of the first and second layers is carried out by chemical vapour deposition (CVD).

8. Method according to one of claims 2 to 7, wherein the growth of the first layer (11) is carried out at a temperature between 1100 and 1500°C, preferably between 1200 and 1400°C.

9. Method according to one of claims 2 to 8, in which the growth of the second layer (12) is carried out at a temperature between 1500 and 2600°C, preferably between 1700 and 1900°C or between 1800 and 2400°C, or even between 2000 and 2250°C.

10. Method according to one of claims 2 to 9, further comprising the introduction of dopants during the growth of the first and second layers.

11. Method according to one of claims 1 to 10, in which the donor substrate (20) is bonded directly to the 4H and/or 6H polytype face of the support substrate.

12. Method according to one of claims 1 to 10, wherein the donor substrate (20) is bonded to the 4H and/or 6H polytype face of the support substrate via a bonding layer (3).

13. Method according to claim 12, wherein the bonding layer (3) comprises silicon or tungsten.

14. Method according to one of claims 1 to 13, further comprising, prior to bonding, a step of implanting atomic species into the donor substrate (20) to form a weakening zone (21) delimiting the active layer (2) and, after bonding, a step of detaching the donor substrate (20) along the weakening zone (21) to transfer the active layer (2) onto the support substrate.

15. Method according to one of claims 1 to 14 in combination with claim 5, further comprising, after transferring the active layer onto the support substrate, removing the first layer (11).

16. Semiconductor structure comprising, in succession, from its rear face to its front face:
- a first layer (11) of polycrystalline SiC mainly of the 3C polytype,
- a second layer (12) of polycrystalline SiC mainly of the 4H and/or 6H polytype,
- an active layer (2) of single-crystal SiC of the 4H or 6H polytype.

17. Structure according to claim 16, wherein:
- the first layer (11) has a thickness of between 80 and 350 µm,
- the second layer (12) has a thickness of between 1 and 20 µm.

18. Structure according to claim 16, wherein:
- the first layer (11) has a thickness of between 80 and 200 µm,
- the second layer (12) has a thickness of between 150 and 270 µm.

19. Electronic device, in particular for power applications or radio frequency applications, comprising the structure according to one of claims 16 to 18 and at least one electronic component, such as a transistor, a diode, a power electronic component, and/or a radio frequency electronic component, arranged in or on the active layer (2).
